# EUROPÄISCHE PATENTSCHRIFT

(11) **EP 0 581 929 B1**
(45) Veröffentlichungstag und Bekanntmachung des Hinweises auf die Patenterteilung: **27.05.1998**
(21) Anmeldenummer: 93903798.2
(22) Anmeldetag: 16.02.1993
(51) Int. Cl.: H03J 1/00, H03J 1/04

(54) **VERFAHREN ZUR EINGABE VON ALPHANUMERISCHEN INFORMATIONEN**
METHOD OF INPUTTING ALPHANUMERIC DATA
PROCEDE POUR L'INTRODUCTION D'INFORMATIONS ALPHANUMERIQUES

(30) Priorität: 21.02.1992 DE 4205338; 16.09.1992 DE 4230912
(43) Veröffentlichungstag der Anmeldung: 09.02.1994
(73) Patentinhaber: ROBERT BOSCH GMBH, 70442 Stuttgart (DE)
(72) Erfinder: SIEGLE, Gert, D-1000 Berlin 38 (DE)
(74) Vertreter: Friedmann, Jürgen, Dr.-Ing.
(86) Internationale Anmeldenummer: DE9300131
(87) Internationale Veröffentlichungsnummer: WO9317496

(56) Entgegenhaltungen:
- EP-A- 0 359 476
- EP-A- 0 401 015
- GB-A- 2 083 722

## Beschreibung

### Stand der Technik

Die Erfindung geht aus von einem Verfahren zur Eingabe von alphnummerischen Informationen in ein elektronisches Gerät nach der Gattung des Hauptanspruchs.

Zur Eingabe von alphanummerischen Informationen in ein elektronisches Gerät ist es beispielsweise bei Computern bekannt, eine Schreibmaschinentastatur zu verwenden, mittels der sowohl Buchstaben als auch Ziffern einzugeben sind. Eine Schreibmaschinentastatur erfordert jedoch verhältnismäßig viel Platz, insbesondere dann, wenn nur wenige Eingaben erforderlich sind oder aber nur kurze Eingaben notwendig sind.

Weiterhin ist es bekannt, Buchstabeninformationen in Codeziffern umzusetzen, die in Codelisten vorhanden sind. Hierbei werden bestimmten Wörtern Ziffern zugeordnet, die dann vom Bediener des Gerätes über eine Zifferntastatur einzutippen sind. Diese Art der Eingabe erfordert jedoch, daß der Bediener des Geräts die Codetabelle bei der Eingabe bei sich führt. Dies ist jedoch in vielen Fällen nicht der Fall, außerdem besteht die Gefahr, daß sich der Bedienende beim Ablesen der Tabelle versieht und so Falscheingaben entstehen. Weiterhin ist bereits vorgeschlagen worden, mittels Richtungstasten das Alphabet zu durchlaufen, so den richtigen Buchstaben auszuwählen, und diesen dann durch das Drücken einer Eingabetaste zu bestätigen. Auch dieses Verfahren verlangt eine erhöhte Aufmerksamkeit vom Bedienenden, da er den Suchlauf an der geeigneten Stelle abstoppen muß und dann den gewünschten Buchstaben bestätigen muß. Insbesondere dann, wenn der Benutzer des elektrischen Geräts durch andere Dinge abgelenkt ist oder anderen Dingen mehr Aufmerksamkeit zuwenden muß, beispielsweise im Straßenverkehr, ist diese Eingabeeart nicht vorteilhaft.

Aus der EP-A-401 015 ist eine Fernbedienung für einen Fernsehempfänger bekannt geworden, der eine alpanummerische Tastatur zeigt, wobei die Tasten 1 bis 0 zumindest auch teilweisen Buchstaben zugeordnet sind. Sollen dabei Buchstaben ausgewählt werden, so ist zuerst eine der Alphatasten zu drücken und danach eine der nummerischen Tasten. Um nun Buchstaben einzugeben, ist es erforderlich, zwei Tasten zu drücken, nämlich einmal die Alphataste und anschließend eine nummerische Taste. Das dort beschriebene Verfahren erfordert jedoch einen hohen Eingabeaufwand, da auf jeden Fall für Buchstabeneingaben zwei Tasten zu drücken sind.

Aus der Druckschrift GB-A-2 083 722 ist ein Rundfunkempfänger bekannt geworden, bei dem alphanummerische Zeichen dadurch eingegeben werden, daß zuerst durch die Tastatur der entsprechende Platz der Eingabe ausgesucht wird und anschließend durch Scrollen das Alphabet von A bis Z angezeigt wird, um an den entsprechenden Platz den entsprechenden Buchstaben zur Anzeige zu bringen. Auf diese Art und Weise sind alphanummerische Eingaben möglich. Auch hier ist jedoch die Bedienung komplex, da einerseits die Stelle festgelegt werden muß, auf dem der Buchstabe oder die Zahl erscheinen soll und außerdem ist das Scrollen in vielen Fällen von Zufälligkeiten abhängig, da es oft nicht gelingt, genau an dem Buchstaben zu stoppen, den man eigentlich wünscht. Auch hier ist daher eine Vielzahl von Tasten zu betätigen, bis ein Buchstabe eingegeben ist.

### Vorteile der Erfindung

Das erfindungsgemäße Verfahren mit den kennzeichnenden Merkmalen des Hauptanspruchs hat demgegenüber den Vorteil, daß das elektronische Gerät mit einer einfachen, handelsüblichen Zifferntastatur auszustatten ist, und trotzdem alphanummerische Eingaben möglich sind, ohne daß vom Bedienenden größere Aufmerksamkeit verlangt wird. Einerseits gestalten sich so ausgestattete Geräte relativ handlich und andererseits ist auch eine für den Bedienenden verständliche Eingabeart möglich, ohne daß er die Anweisung, die er dem Gerät übermitteln möchte, in eine für ihn unverständliche Maschinensprache umsetzen muß.

Ist die Anweisung eindeutig, so wird die Information vorteilhafte Weise sofort in einen entsprechenden Befehl für das Gerät umgesetzt. In diesem Fall wird der Bedienende besonders entlastet. Bei Unklarheiten werden dem Bedienenden ein Auswahlmenü aufgezeigt, so daß er eventuell vorhandene Unklarheiten lediglich durch die Eingabe eines weiteren Tastendruckes beseitigen kann. Spätestens nach diesem Tastendruck wird dann die entsprechende Gerätefunktion oder Aktion veranlaßt.

Durch die in den Unteransprüchen aufgeführten Maßnahmen sind vorteilhafte Weiterbildungen und Verbesserungen des im Hauptanspruch angegebenen Verfahrens möglich. Besonders vorteilhaft ist, die Mehrdeutigkeit der eingegebenen Information durch Sonderzeichen zu kennzeichnen, insbesondere durch Pfeile in der Anzeige. Vorteilhaft ist es, neben den rein numerischen Tasten ein oder zwei Sondertasten vorzusehen, mittels der die Bediensequenzen zu differenzieren oder abzuschließen sind. Hierdurch wird es möglich, auch eine Leerinformation einzugeben oder das Ende der Eingabe zu kennzeichnen. Das erfindungsgemäße Verfahren ist besonders vorteilhaft dort einzusetzen, wo die Aufmerksamkeit des Bedienenden durch andere Ereignisse mehr beansprucht wird. Dies ist inbesondere bei Rundfunkempfängern der Fall, die in Fahrzeugen eingesetzt werden. Eine besonders einfache Eingabevorrichtung ist auch bei Navigationsgeräten im Fahrzeug oder bei Telefonen, insbesondere bei mobilen Telefon erforderlich.

Die Eingabetastatur ist am einfachsten durch eine an sich bekannte Ziffernblocktastatur zu realisieren. Ziffernblocktastaturen werden für Telefone in großen Stückzahlen recht preisgünstig hergestellt, so daß sich das damit ausgestattete Gerät nicht oder nur unwesentlich verteuert. Als Sondertasten können hierbei insbesondere die nicht mit Ziffern belegten Tasten der Telefontastatur, insbesondere die Sterntaste und die Rautentaste Verwendung finden. Weiterhin ist es vorteilhaft, eine Sprachausgabe vorzusehen, wenn der Fahrer nicht durch einen Blick auf eine optische Anzeige gelenkt werden soll.

Hierdurch wird es dem Fahrer möglich, ohne weiteres zu erkennen, ob er die richtige Anweisung eingegeben hat oder ob mehrere Anweisungen aufgrund von Doppeldeutigkeiten zu beachten sind. Besonders vorteilhaft ist das Einlesen der zuverlässigen alphanummerischen Eingabe von einer Smart-Card, einem externen Speicher oder einem externen Rechner, da dadurch große Datenmengen oder festgelegte Datenfolgen automatisch eingelesen werden können. Die Vorteile der Datenfernübertragung und der Vernetzung von Systemen können genutzt werden.

In Verbindung mit Rundfunkempfängern ist es besonders vorteilhaft, wenn der Bediener des Rundfunkempfängers die Station, die er zu empfangen wünscht in Klartext eingibt. Der Bedienende kann daher die gewünschte Station, z.B. Norddeutsche Rundfunk, zweites Programm (NDR2) direkt in das Gerät eingeben, wobei das Gerät dann den entsprechenden Sender automatisch einstellt. Die Einstellung des Senders erfolgt durch Vergleich des eingegebenen Codes mit dem vom Sender übertragenen Code, wobei die Codeübertragung beispielsweise über das an sich bekannte RDS-System erfolgt. Ergibt sich dabei eine Mehrdeutigkeit der Eingabe, ist es vorteilhaft, die möglichen Sender anzuzeigen, und mittels der Tastatur eine Auswahl zu treffen.

Vorteilhaft ist besonders die Verwendung der Ortskennzahlen für die Eingabe des Standortes und der Richtung, da diese allgemein bekannt und einfach zu handhaben sind. Die Auswahl der Verkehrsnachrichten bei RDS -Empfänger n mit digitalen Verkehrsnachrichten kann unter Benutzung der Ortskennzahlen präzise vorgenommen werden, ohne daß der Fahrer besondere Kenntnisse aufweisen oder ein kompliziertes Eingabeverfahren erlernen muß.

### Zeichnung

Ausführungsbeispiele der Erfindung sind in der Zeichnung dargestellt und in der nachfolgenden Beschreibung näher erläutert. Es zeigen Figur 1 einen Rundfunkempfänger als elektronisches Gerät mit einer Bedientastatur, Figur 2 einen Speicher im Rundfunkempfänger, Figur 3 ein Struktogramm über die Arbeit des Steuerrechners bezüglich der Informationseingabe, Figur 4 einen Speicher zur Zuordnung von Frequenzen zu den eingegebenen Stationen, Figur 5 ein Navigationsgerät mit einer Eingabetastatur, Figur 6 einen Speicher im Navigationsgerät, Figur 7 ein Struktogramm zur Verwendung der Ortskennzahlen zur Standort- und Richtungsangabe, Figur 8 eine Tabelle zur Zuordnung der Ortskennzahlen zu den geographischen Längen- und Breitengraden der Orte und Figur 9 eine schematische Darstellung einer Ziffernblocktastatur.

### Beschreibung der Ausführungsbeispiele

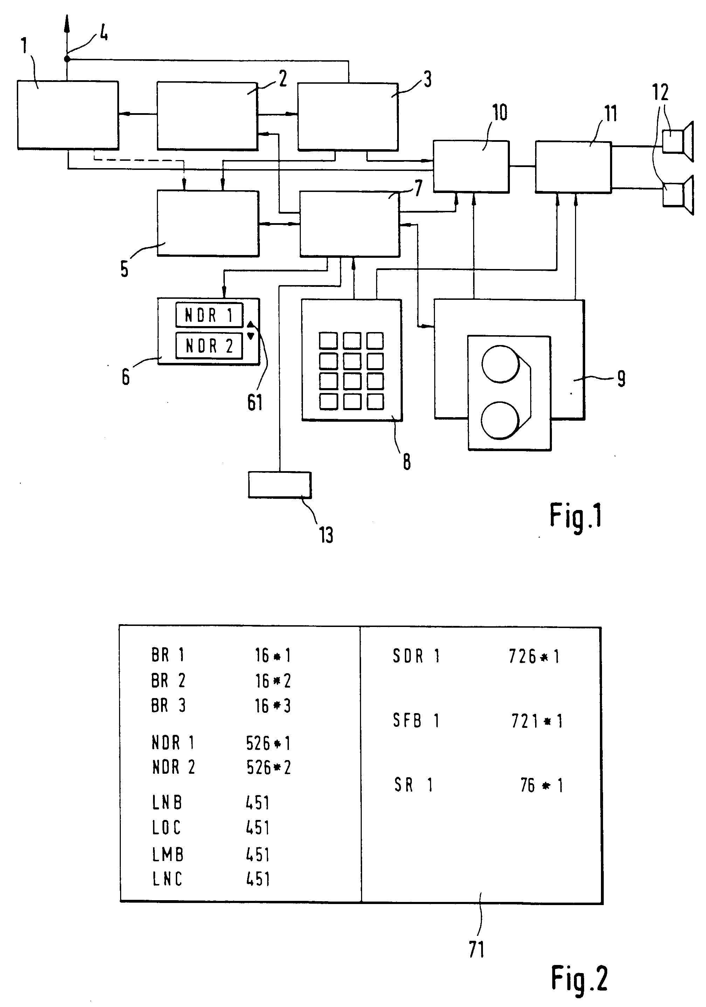

Figur 1 zeigt einen Rundfunkempfänger, der in diesem Fall einen an sich bekannten AM-Tuner 1 und einen ebenfalls an sich bekannten FM-Tuner 3 aufweist. Die Tuner 1 und 3 sind gemeinschaftlich mit einer Antenne 4 verbunden, die an das Rundfunkgerät anschließbar ist. Weiterhin ist ein Abstimmsystem 2 vorgesehen, mit dem die Empfangsfrequenz des AM- bzw. FM-Tuners einstellbar ist. Der Rundfunkempfänger weist weiterhin einen an sich bekannten RDS-Decoder 5 auf, mit dem es möglich ist, digital mit der Rundfunksendung übertragene Informationen aufzunehmen und auszuwerten. Der RDS-Decoder 5 empfängt beispielsweise als Ascii-Zeichen den Stationsnamen, sowie die Frequenzen, auf der das entsprechende Programm ebenfalls zu hören ist. Weiterhin sind im RDS-Decoder 5 Informationen bezüglich Verkehrsnachrichten auswertbar. Die vom RDS-Decoder 5 aufgenommenen und decodierten Informationen gelangen zum zentralen Steuerrechner 7, wobei sich dieser Steuerrechner 7 aus einem Rechner und Speichern zusammensetzt. Die Speicher enthalten teilweise Programme zum Betrieb des Geräts als auch weitere Informationen, wie dies später noch erläutert wird. Der Rechner 7 steht im gezeigten Beispiel mit dem Abstimmsystem 2 zum Abstimmen der entsprechenden Empfangsfrequenz und mit einer Quellenwahleinrichtung 10 zur Auswahl der Datenquelle in Verbindung. Des weiteren tauscht der Rechner 7 mit dem RDS-Decoder 5 Daten und Informationen aus. Der Rechner 7 betreibt des weiteren eine Anzeige 6, um dort die empfangenen bzw. eingegebenen Sender darzustellen. Schließlich ist der Rechner 7 auch mit einer Zifferntastatur 8 verbunden, die die Eingabe von Informationen ermöglicht. Für den Datenaustausch mit einer Smard-Card, einem externen Speicher oder einem externen Rechner ist der Rechner 7 mit einer Schnittstelle 13 ausgerüstet. Über den Rechner erfolgt im gezeigten Beispiel weiterhin die Quellenwahl, so daß an den Audioverstärker 11 entweder das Signal des FM-Turners, das AM-Turners oder eines weiteren vorhandenen Geräts 9 übertragbar ist. Das weitere Gerät 9 kann beispielsweise ein Kassettenoder ein Kompaktdiskspieler sein, wobei diese Spieler ebenfalls mit dem Speicher in Verbindung stehen können. So wird es nämlich möglich, mittels einer eingelegten CD Daten in die Speicher des Rechners 7 zu übertragen oder aber Daten von dem weiteren Gerät 9 abzurufen. Mit dem Audioverstärker stehen schließlich zwei Lautsprecher in Verbindung, mit denen es möglich wird, das empfangene Programm abzuhören.

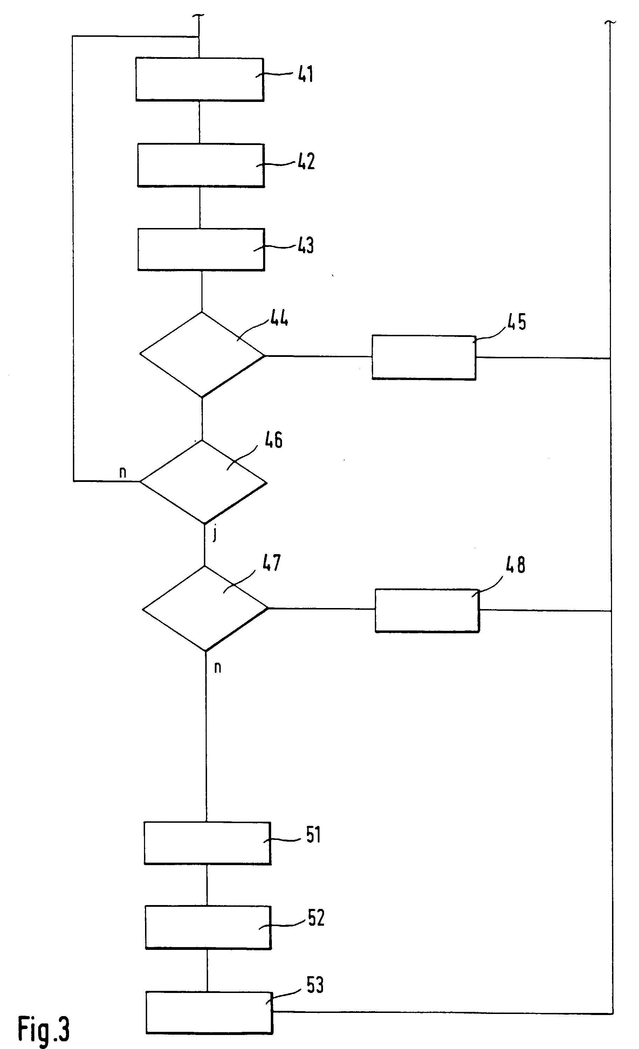

Die Funktionsweise des Gerätes soll in Verbindung mit den Figuren 2 und 3 näher erläutert werden. Figur 2 zeigt einen Datenspeicher, wie er beispielsweise im Rundfunkempfänger abgelegt ist, während Figur 3 als Struktogramm das Programm enthält, das vom Rechner 7 bezüglich der Eingabe abgearbeitet wird. Die Tastatur 8 ist als handelsübliche Telefontastatur ausgebildet. Hierbei sind in der oberen Reihe die Tasten 1, 2 und 3, in der nächsten Reihe die Tasten 4, 5 und 6, in der zweiten Reihe von unten die Tasten 7, 8 und 9 und in der untersten Reihe die Tasten *, 0 und # angeordnet. Der Taste 1 sind gleichzeitig die Buchstaben A, B und C, der Taste 2 die Buchstaben D, E, F, der Taste 3 die Buchstaben G, H, I, der Taste 4 die Buchstaben J, K, L, der Taste 5 die Buchstaben M, N, O, der Taste 6 die Buchstaben P, Q, R, der Taste 7 die Buchstaben S, T, U, der Taste 8 die Buchstaben V, W, der Taste 9 die Buchstaben X, Y, Z und der Taste 0 die Buchstaben Ä, Ö, Ü zugeordnet. Andere Zuordnungen sind möglich und vorgesehen. Aufgrund dieser Buchstabenordnung ist es nun möglich, in die Tastatur direkt und in Klartext die Sender einzutippen, die man hören möchte. Diese Sender sind in dem Speicher 71 im Rechner 7 des Rundfunkgeräts enthalten oder werden nach Einschalten des Gerätes von einem Datenträger 9 in den Arbeitsspeicher des Rechners 7 überspielt, wie dies beispielhaft in Figur 2 dargestellt ist. In Deutschland übliche Abkürzungen sind beispielsweise BR wie Bayerischer Rundfunk, NDR wie Norddeutscher Rundfunk, SDR wie Süddeutscher Rundfunk, SFB wie Sender Freies Berlin und SR wie Saarländischer Rundfunk. Die Abkürzungen LMB, LOC, LNB und LNC kennzeichnen z.B. andere Rundfunksender.

Die Ziffern hinter den Sendern bezeichnen die unterschiedlichen Programme, die von den einzelnen Sender ausgesendet werden. So senden in Deutschland die Sender üblicherweise drei oder mehr Programme aus, die durch die dahintergestellten Ziffern gekennzeichnet sind. Den Programmen zugeordnet sind die entsprechenden Zifferntasten die vom Bedienenden zu drücken sind. Wünscht daher der Bedienende des Autoradios den Bayerischen Rundfunk zu empfangen, so drückt er erst die Taste 1, da ihr die Buchstaben A, B, C zugeordnet sind und danach die Taste 6, da dieser Taste die Buchstaben P, Q, R zugeordnet sind. Wünscht er das dritte Programm des Bayerischen Rundfunks zu empfangen, drückt er dann die Leertaste, was im Ausführungsbeispiel ein Stern bedeutet. Anschließend drückt er die 3 für das dritte Programm, so daß vom Bedienenden die Tastenfolge 1, 6, *, 3 einzugeben ist. Hat er diese Eingabe beispielsweise durch Drücken des Rauten-Zeichens bestätigt, so überprüft nun der Mikroprozessor 7 die Tabelle gemäß Figur 2 und stellt fest, daß sich bei der Tastatureingabe 1, 6 * 3 nur eine Möglichkeit ergibt, nämlich den Empfang von BR3. Dieses Programm wird nun in der Anzeige 6 dargestellt und mittels des Abstimmsystems 2 eingestellt, so daß der Bediener des Geräts nun den Sender BR3 empfängt. Alternativ kann die Wahl der Leertaste entfallen, so daß sich die Zeichensequenz im vorhergehenden Beispiel zu 1,6,3 ergibt.

Dies sei im einzelnen anhand des Struktogramms nach Figur 3 näher erläutert. Zuerst wird an der Stelle 41 vom Bediener eine Zahlentaste gedrückt und eingegeben, die gleichzeitig Buchstaben repräsentieren kann. An der Stelle 42 wird nun der Taste allen möglichen Buchstaben zugeordnet. Dies bedeutet, daß der Taste 1 neben der Zahl 1 die Buchstaben A, B, C, der Taste 2 die Buchstaben G, E, F und so weiter zugeordnet werden. Anschließend wird an der Stelle 43 ein Vergleich mit dem im Gerät abgelegten Speicher durchgeführt, im Falle eines Rundfunkgerätes mit dem Speicher 71. An der Stelle 44 wird nun geprüft, ob eine entsprechende Kombination vorhanden ist, es sich also um eine gültige Eingabe handelt. Würde im Ausführungsbeispiel der Bediener des Gerätes beispielsweise den Buchstaben G im Sinne haben und deswegen die dritte Taste drücken, so würde anhand des Speichers 71 festgestellt werden, daß eine solche Eingabe nicht vorgesehen ist. An der Stelle 45 wird daher diese Kombination als ungültig verworfen und der Bediener aufgefordert, eine gültige Kombination einzugeben. Hat er beispielsweise die Taste 1 gedrückt, so wird anhand der Stelle 44 festgestellt, daß bezüglich der Taste 1 und bezüglich der ersten Eingabe nur eine Alternative möglich ist, nämlich das B. An der Stelle 46 wird nun geprüft ob die Eingabe beendet ist. Ist das nicht der Fall, werden die Schritte 41, 42, 43 und 44 nochmals durchlaufen, es wird also eine neue Eingabe erwartet, es wird wieder eine Kontrolle der Kombination durchgeführt und auf gültige oder ungültige Eingaben geprüft. Wird als zweite Eingabe beispielsweise die Taste 5 gedrückt, so würde auch diese Eingabe an der Stelle 44 als nicht gültig verworfen, da eine Kombination der Tasten 1, 5 im Speicher 71 gemäß Figur 2 nicht vorgesehen ist. Im Ausführungsbeispiel wäre lediglich die Kombination der Tasten 1, 6 zugelassen. Wird an der Stelle 46 nach der Eingabe der ersten und der sechsten Taste beispielsweise durch eine Eingabe der Raute abgebrochen, so springt das Programm an die Stelle 47 und prüft ob diese Eingabe eindeutig ist. Bei dem oben angenommenen Beispiel ist dies jedoch nicht der Fall. Eindeutig wäre die Eingabe nur dann gewesen, wenn der Bediener z.B. zusätzlich noch die Angabe *3 gemacht hätte, da nun eine eindeutige Zuordnung zum Sender Bayern 3 möglich gewesen wäre. Dann hätte das Programm zur Stelle 48 verzweigt und den Sender Bayern 3 in der nachher beschriebenen Art und Weise eingestellt.

Da jedoch im Beispiel der Wunsch nach dem dritten Programm nicht geäußert wurde, ist gemäß dem Speicherinhalt im Speicher 71 die Aussage mehrdeutig, da sowohl das erste das zweite als auch das dritte Programm gemeint sein könnte. Das Programm verzweigt daher an die Stelle 51 und bietet nun ein Auswahlmenü an, wo der Bedienende gefragt wird ob er nun das erste, das zweite oder das dritte Programm hören will. Durch Betätigen der Tasten 1 2 3 der Abfragestelle 52 ist es möglich, die fehlende Information nachzuholen, so daß die Einstellung des entsprechenden Senders hier an der Station 53 erfolgt. Sind die eingegebenen Werte an der Station 45 als nicht gültig verworfen worden oder hat eine Einstellung entweder aufgrund der Eineindeutigkeit der Ergebnisse an der Station 48 oder aufgrund der Auswahl an der Station 53 stattgefunden, wird das Programm verlassen und der Mikrorechner nimmt weitere Aufgaben dar.

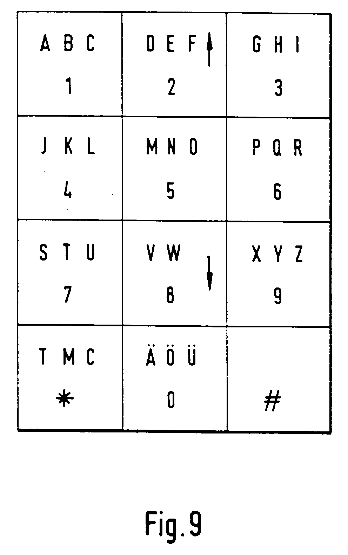

Während in dem soeben aufgezeigten Beispiel das Auswahlmenü aufgrund einer unvollständigen Eingabe aufgerufen wurde, kann es auch vorkommen, daß das Auswahlmenü aufgrund von Doppeldeutigkeiten der Information zum Tragen kommt. Will beispielsweise der Bedienende die Station LOC eingeben, so muß er gemäß der getroffenen Vereinbarung die Tastenfolge 4, 5, 1 drücken. Neben der Station LOC müßte er jedoch auch diese Tastenkombination drücken, wenn er die Station LMB, LNC oder LNB zu empfangen wünscht. Durch den Rechner des Rundfunkempfängers ist es nun nicht möglich zu entscheiden, welche Station der Bedienende eigentlich hören möchte. Auch in diesem Fall wird trotz einer richtigen und vollständigen Eingabe an die Auswahlstelle 51 verzweigt, wobei ihm nun die Sender LMB, LOC, LNB und LNC zur Auswahl angeboten werden. Durch Betätigung der entsprechenden Auswahltaste (↑,↓) ist es nun möglich, den Sender LOC auszuwählen. Die Auswahltasten (↑,↓) sind vorzugsweise auf den Tasten, die mit der Ziffer 2 bzw. 8 belegt sind, oder auf gesonderten Sondertasten angeordnet.(vgl. Fig.9)

Wie ohne weiteres erkennbar wird, wird die Eingabe mittels der Eingabetastatur umso sicherer, je länger das Wort ist, das den Befehl beschreibt. Würde beispielsweise das Wort "Norddeutscher Rundfunk" vollständig eingegeben, so sind Verwechslungen mit anderen Worten kaum möglich, da aufgrund der Vielzahl der eingegebenen Tastenwerte meist eine eineindeutige Zuordnung möglich ist. Vielfältigkeiten treten jedoch bei relativ kurzen Worten, wie beispielsweise Senderabkürzungen auf, wie am Beispiel LMB, LOC gezeigt ist. Doppeldeutigkeiten sind auch dann nicht zu vermeiden, wenn sie vom Bedienenden gewünscht wird, wenn er also beispielsweise durch eine unvollständige Eingabe eine Auswahl geboten haben möchte, beispielsweise wenn er nicht weiß, wieviel verschiedene Programme von einer bestimmten Rundfunkstation ausgesendet werden.

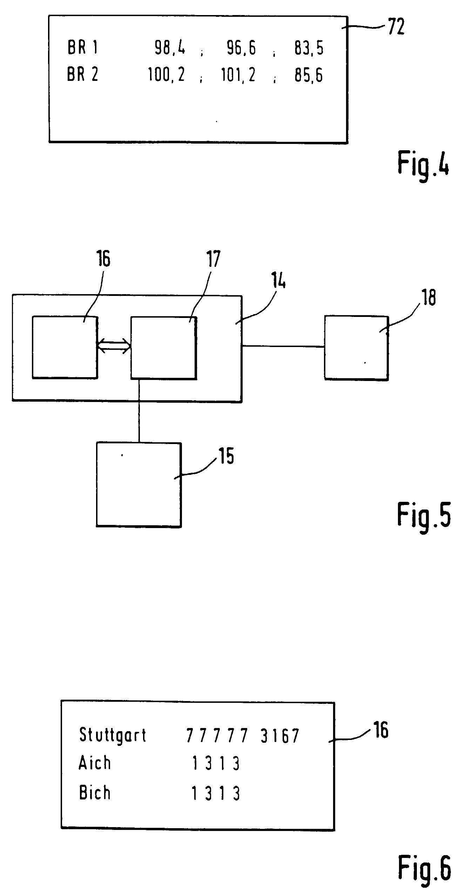

Hat nun der Bedienende den Wunsch geäußert, beispielsweise den Sender Bayern 1 (BR1) zu hören, so schaut der Rechner 7 in dem ihm zugeordneten in Figur 4 dargestellten Speicher 72 nach und findet hier, daß der Sender Bayern 1 auf den Frequenzen 98,4, 96,6 und 83,5 Megahertz zu hören ist. Der Rechner 7 veranlaßt nun das Abstimmsystem 2, der Tuner 3 auf diese Frequenzen abzustimmen und festzustellen, wo das beste Signal zu empfangen ist. Diese Frequenz wird ausgewählt und der Hörer kann nun das Programm von Bayern 1 hören. Gleichzeitig wird dieser Sender auf der Anzeige 6 als einziger Sender angezeigt.

Die Anzeige 6 in Figur 1 zeigt übrigens den Fall, daß vom Bedienenden die Tasten 5, 2 und 6 gedrückt wurden. In diesem Fall erscheint das Symbol 61, das kennzeichnet, daß eine Auswahl getroffen werden muß, während gleichzeitig zwei der Auswahlmöglichkeiten in der Anzeige 6 dargestellt wird. Alternativ ist es des weiteren möglich, statt einer visuellen Anzeige eine akustische Anzeige vorzusehen, indem beispielsweise die Information für die weitere Bedienung über die Lautsprecher 12 des Rundfunkempfängers ausgegeben werden. Es sei auch darauf hingewiesen, daß der Speicher 71 gemäß Figur 2 nur einen kleinen Ausschnitt der möglichen zu speichernden Eingabemöglichkeiten enthält. Neben den Senderbezeichnungen im Kurztext könnten diese auch in Langtext eingegeben sein, sowie weitere Informationen über die Wahl des zu hörenden Programms beispielsweise Musik, Nachrichten oder ähnliches aufgegliedert sein.

Sind sehr umfangreiche Informationen abzurufen, kann es leicht geschehen, daß der Speicherinhalt so groß wird, daß es nicht zweckmäßig ist, diesen in einem Festwertspeicher im Mikroprozessor 7 vorrätig zu halten. In diesem Fall ist es auch möglich, als Speichermedium den Kassetten- oder CD-Spieler 9 des Rundfunkempfängers zu nutzen, in dem relativ umfängliche Daten abzulegen sind. Diese Art der Datenablage erleichtern auch das Auswechseln von aktuellen Daten, beispielsweise bei der Umbenennung von Sendern (Mitteldeutscher Rundfunk) oder bei der Änderung der Frequenzen der Rundfunkstationen, die in dem Speicher 72 in Figur 4 abgelegt sind.

Figur 5 zeigt ein weiteres Ausführungsbeispiel in Verbindung mit der Erfindung. Hierbei ist ein an sich bekanntes Navigationssystem 14 dargestellt, mit einem Navigationsrechner 17 sowie einem Speichermedium 16, das in digitalisierter Form die Landkarte enthält sowie Ortsangaben. Ebenfalls dargestellt ist die Zifferntastatur 15 und eine Sprachausgabe 18. Mittels der Zifferntastatur 15 ist in der zuvor beschriebenen Weise das Fahrtziel einer Reise oder der augenblickliche Standort einzugeben. Für die Eingabe von "Stuttgart" sind hierbei die Tasten 777773167 zu drücken und durch eine Raute das Ende der Eingabe zu bestätigen. Auch hier sind Doppeldeutigkeiten möglich, beispielsweise wenn der Reisende das Ziel Aich erreichen will und die Ziffernfolge 1313 eingibt. Hierbei könnte auch der Ort Bich gemeint werden, so daß mittels eines Auswahlmenüs die Entscheidung getroffen werden muß. Das gleiche wäre der Fall, wenn beispielsweise vom Reisenden die Eingabe Kirchheim gemacht würde, da Kirchheim ein in Deutschland sehr geläufiger Name ist und deswegen Doppeldeutigkeiten nicht zu vermeiden sind.

Genauso wie der Ort sind auch Straßen eingebbar. Beispielhaft ist es möglich, z.B. Hauptstrasse 50 durch Drücken der Tasten 3176777*50 einzugeben. Mittels der Ziffertastatur ist es daher möglich, auch umfängliche Worte einzugeben, ohne daß es einer großen alphanumerischen Tastatur bedarf. Wesentlich dabei ist, daß ein Speicher vorhanden ist, in dem die möglichen Kombinationen aufgezeigt sind, so daß aufgrund einer Eingabe eine Umsetzung in maschinenverständliche Zahlen möglich wird und gleichzeitig die Eineindeutigkeit der Eingabe gesichert ist.

Figur 6 zeigt beispielsweise den Speicher 16, wie er in Verbindung mit einem Navigationssystem zum Einsatz kommt. Aufgrund der hier erforderlichen relativ großen Datenmengen, die sich auch leicht ändern können, bietet sich hier die Verwendung einer CD-ROM als Speicher an.

Die Eingabe von alphanumerischen Informationen ist nicht auf dieses Ausführungsbeispiel beschränkt. In Verbindung mit Rundfunkempfängern ist es möglich, ebenfalls einen Speicher gemäß Figur 6 zusätzlich zu den Speichern 71 und 72 im Rundfunkempfänger mitzuführen. Hierdurch wird es möglich, Eingaben von bestimmen Orten oder Regionen vorzunehmen, um beispielsweise nur Verkehrsmeldungen nach dem TMC-System für solche Orte oder Regionen zuzulassen, die eingegeben worden sind. Dadurch läßt sich die Zahl der empfangenen Verkehrsmeldungen reduzieren.

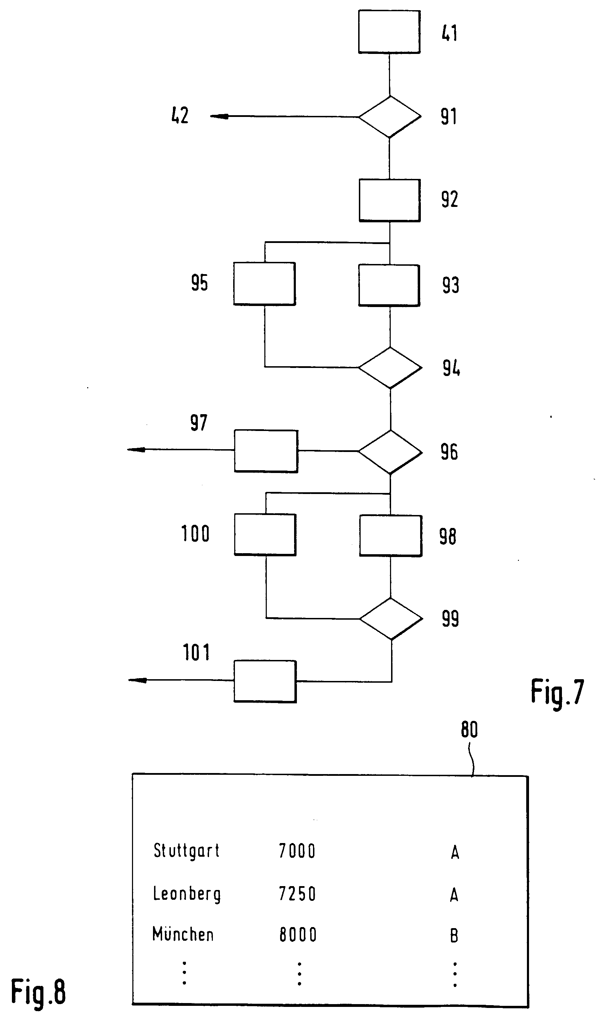

Eine weitere Ausbildung der Erfindung besteht darin, eine Standortbestimmung und eine Richtungsangabe über die Eingabe von Ortskennzahlen zu ermitteln. Anhand des Struktogramms in Figur 7 wird die Vorgehensweise des Verfahrens erklärt. Nach dem Betätigen einer Taste bei Punkt 41 (vgl. Fig. 3) erfolgt bei Punkt 91 eine Überprüfung des ersten eingegebenen Wertes. Handelt es sich um einen Ziffernwert, so wird nach Programmpunkt 42 verwiesen und wie anhand von Figur 3 erläutert verfahren. Wurde eine Sondertaste betätigt, so werden bei Punkt 92 den Tasten auf jeden Fall die entsprechenden Ziffern, die auf den Tasten angegeben sind, zugeordnet. Bei Punkt 93 erfolgt die Eingabe weiterer Zahlen, die eine Ortskennzahl ergibt, wobei die Eingabe mit einer Stern- oder Rautentaste abgeschlossen wird. Will der Bedienende den Standort eingeben, so wird die Eingabe mit der Rautentaste abgeschlossen. Möchte der Bedienende neben dem Standort gleichzeitig eine Richtung eingeben, so wird als Abschluß die Sterntaste verwendet. Bei Punkt 94 wird die Zahlenkombination mit den in der Tabelle 80 abgelegten Ortskennzahlen verglichen. Die Tabelle 80 ist in Figur 8 dargestellt. Befindet sich die eingegebene Zahlenkombination nicht in der Tabelle, so wird bei Punkt 95 die eingegebene Zahlenkombination vom Bedienrechner gelöscht, eine Fehlerausgabe mittels der Anzeigevorrichtung angegeben und nach Punkt 93 zurückgesprungen. Die Eingabe muß erneut getätigt werden. Bei Übereinstimmung der eingegebenen Zahlenkombination mit einer in der Tabelle abgelegten Kombination wird in Punkt 96 überprüft, ob die Zahleneingabe mit einer Stern- oder einer Rautentaste abgeschlossen wurde. Bei Abschluß mit einer Rautentaste wird nach Programmpunkt 97 verzweigt. Dort ermittelt der Rechner mittels der in der Tabelle abgelegten Angaben den Standort. Mit der Standortangabe ist es möglich, Verkehrsnachrichten auf den Standort bezogen anzugeben. Nach dieser Ausführung wird zu einem weiteren Programm verzweigt. Wurde die Eingabe der Zahlenkombination bei Punkt 93 mit einer Sterntaste abgeschlossen, das heißt der Bedienende möchte eine Richtung eingeben, so wird vom Rechner die Eingabe einer weiteren Information bei Punkt 98 erwartet. Der Bedienende gibt die Zahlen mittels Tasten ein und schließt die Eingabe mit der Sondertaste "Raute" ab. Bei Punkt 99 wird die zweite eingegebene Information ebenfalls mit den in der Tabelle 80 abgelegten Ortskennzahlen verglichen. Findet sich die eingegebene Zahlenkombination nicht in der Tabelle, so wird bei Programmpunkt 100 vom Bedienrechner mittels einer Anzeigevorrichtung eine Fehlerausgabe ausgegeben und nach Punkt 98 zurückverwiesen, so daß die Eingabe des zweiten Ortes erneut getätigt werden muß. Findet sich die eingegebene Zahlenkombination in der Tabelle, so ermittelt der Rechner bei Programmpunkt 101 den Standort und den Weg, der vom ersten zum zweiten eingegebenen Ort führt. Nunmehr ist es möglich, z.B. Verkehrsinformationen gezielt für eine bestimmte Fahrtrichtung anzugeben. Nach Punkt 101 wird zu einem weiteren Programm 41 verzweigt.

Figur 9 zeigt schematisch eine Ziffernblocktastatur. Die Tasten sind erfindungsgemäß mit Ziffern, Sonderzeichen und Buchstaben belegt. In diesem gewählten Beispiel sind jeder Zifferntaste und der Sterntaste jeweils 3 Buchstaben zgeordnet. Die Zifferntaste 2 und 8 sind zusätzlich noch mit den Sonderzeichen "Pfeile" (↑,↓) belegt. Werden z.B. mehrere Sendern zur Auswahl angeboten, so wird mithilfe der Sonderzeichen "Pfeile" der Sender bestimmt.

## Patentansprüche

1. Verfahren zur Eingabe von alphanumerischen Informationen in ein elektronisches oder elektronisch gesteuertes Gerät, insbesondere in Rundfunkempfänger, Telefone, Navigations-, Ortungsgeräte und Maschinensteuerungen, wobei das Gerät einen Bedienrechner mit einem Speicher und eine Tastatur aufweist, und wobei einigen oder allen Tasten mehr als ein Buchstabe des Alphabets zugeordnet ist, dadurch gekennzeichnet, daß nach der Betätigung einer oder mehrerer der mit Buchstaben belegten Tasten im Speicher (71) des elektronischen Gerätes nach der oder den dort abgelegten Buchstaben-Kombinationen gesucht wird, die aufgrund der Tastatureingabe möglich und zulässig sind, daß die gefundenen Kombinationen zwischengespeichert werden und daß nach Beendigung der Eingabe die gefundenen, zulässigen Buchstaben-Kombinationen zur Weiterverwendung gespeichert, angezeigt, oder akustisch ausgegeben werden, daß bei nur einer gefundenen und zulässigen Ziffern-Buchstaben-Kombination die zugehörige Gerätefunktion/-aktion veranlaßt wird, daß bei mehreren als zulässig gefundenen Ziffern-Buchstaben-Kombinationen diese als Auswahlmenü angezeigt oder akustisch angegeben werden und aufgrund eines weiteren Eingabebefehls die gewünschte Kombination ausgesucht und die zugehörige Gerätefunktion/-aktion veranlaßt wird.

2. Verfahren nach Anspruch 1, dadurch gekennzeichnet, daß die Tastatur eine Zifferntastatur, vorzugsweise eine Zehnertastatur enthält und daß jeweils einigen Buchstaben einzelne Ziffern zugeordnet sind.

3. Verfahren nach Anspruch 2, dadurch gekennzeichnet, daß jeder Ziffer nicht mehr als drei Buchstaben zugeordnet sind.

4. Verfahren nach einem der Ansprüche 1 bis 3, dadurch gekennzeichnet, daß der Hinweis auf mehrere gefundene zulässige Ziffern-Buchstaben-Kombinationen durch ein oder mehrere Sonderzeichen, vorzugsweise durch Pfeile in einem Display, angezeigt wird.

5. Verfahren nach einem der Ansprüche 1 bis 4, dadurch gekennzeichnet, daß eine oder mehrere Nicht-Zifferntasten zur Differnzierung innerhalb der Bediensequenzen, vorzugsweise Umschalten von Buchstaben- auf Ziffernbedeutung oder als Leertaste vorgesehen sind.

6. Verfahren nach einem der Ansprüche 1 bis 5, dadurch gekennzeichnet, daß die zulässigen alphanumerischen Kombinationen und die zugehörige Tastenbedienung in den Speicher des Rechners von einer Smart-Card, einem externen Speicher oder einem weiteren Rechner eingelesen werden.

7. Verfahren nach einem der Ansprüche 1 bis 6, dadurch gekennzeichnet, daß als elektrisches Gerät ein Rundfunkempfänger verwendet wird, daß im Speicher (71) des Rundfunkempfängers Senderbezeichnungen als Buchstaben-/Ziffernkombination abgelegt sind, und daß der Rechner nach alphanummerischer Eingabe des Senders die Kennungen der mittels RDS-Decoder empfangenen Sender mit den gewählten Sendern vergleicht und die entsprechende Frequenz in einem Tuner eingestellt wird.

8. Verfahren nach Anspruch 1 bis 6, dadurch gekennzeichnet, daß im Speicher eine Tabelle mit zugeordneten Postleitzahlen und/oder geographischen Längen und Breiten und/oder Zulassungskennzeichen der Kraftfahrzeuge abgelegt wird und daß zur Standort-oder Zielbestimmung die Postleitzahl oder die Zulassungsbuchstaben der Kraftfahrzeuge eingegeben wird.

9. Verfahren nach Anspruch 8, dadurch gekennzeichnet, daß nach der Standorteingabe ein weiterer Ort mittels Postleitzahl oder Zulassungsbuchstaben der Kraftfahrzeuge eingegeben wird und der Rechner aus den Längen und Breitenangaben oder den Zulassungsbuchstaben der Kraftfahrzeuge die Richtungs- und Entfernungsangabe errechnet und gegebenenfalls eine oder mehrere Fahrtrouten auf einem Display darstellt.

## Claims

1. Method of inputting alphanumeric information into an electronic or electronically controlled device, in particular in radio receivers, telephones, navigation equipment and machine controllers, the device having an operating computer with a memory and a keypad and more than one letter of the alphabet being assigned to a number of the keys or to all the keys, characterized in that after the actuation of one or more of the keys in the memory (71) of the electronic device, which keys are provided with letters, a search is made for the letter combination or combinations which are stored there and which are possible and acceptable on the basis of the keypad entry, in that the combinations which are found are buffered and in that after the entry has been terminated the acceptable letter combinations which have been found are stored for further use, displayed or output audibly, in that the associated device function/action is brought about only when an acceptable number/letter combination has been found, in that if a plurality of number/letter combinations are found to be acceptable they are displayed or indicated audibly as a selection menu and the desired combination is searched for and the associated device function/action is brought about on the basis of a further input instruction.

2. Method according to Claim 1, characterized in that the keypad includes a numerical keypad, preferably a ten-key numerical keypad, and in that individual numbers are assigned in each case to some letters.

3. Method according to Claim 2, characterized in that each number is assigned not more than three letters.

4. Method according to one of Claims 1 to 3, characterized in that the indication of a plurality of acceptable number/letter combinations which have been found is given by means of one or more special characters, preferably by means of arrows in a display.

5. Method according to one of Claims 1 to 4, characterized in that one or more non-numerical keys are provided for differentiating within the operating sequences, preferably switching over from letters to numerical values or as a space key.

6. Method according to one of Claims 1 to 5, characterized in that the acceptable alphanumeric combinations and the associated key operation are input into the memory of the computer by a smart card, an external memory or a further computer.

7. Method according to one of Claims 1 to 6, characterized in that a radio receiver is used as electrical device, in that transmitter designations are stored, as letter/number combinations, in the memory (71) of the radio receiver, and in that after the alphanumeric input of the transmitter the computer compares the identifications of the transmitters received by means of an RDS decoder with the selected transmitters and the corresponding frequency is set in a tuner.

8. Method according to one of Claims 1 to 6, characterized in that a table with associated postcodes and/or geographic longitudes and latitudes and/or registration numbers of motor vehicles are stored in the memory, and in that the postcode or the registration numbers of motor vehicles are input in order to determine the present location or destination.

9. Method according to Claim 8, characterized in that after the present location has been input a further location is input by means of postcode or registration numbers of motor vehicles and the computer calculates the direction and distance information from the longitude and latitude information or the registrations numbers of motor vehicles and possibly displays one or more routes on a display.

## Revendications

1. Procédé servant à l'entrée de données d'informations alphanumériques dans un appareil électronique ou dans un appareil commandé électroniquement, en particulier dans un récepteur radio, dans des téléphones, des appareils de navigation ou de localisation, et des commandes de machines, dans lequel l'appareil présente un ordinateur de manoeuvre avec une mémoire et un clavier, et dans lequel on associe, à quelques touches ou à toutes les touches, plus d'une lettre de l'alphabet,
caractérisé en ce que
- après l'actionnement d'une ou de plusieurs des touches pourvues de lettres, on cherche dans la mémoire (71) de l'appareil électronique la ou les combinaisons de lettres déposées à cet endroit qui sont possibles ou permises en fonction de l'entrée de données effectuée au moyen du clavier,
- l'on met entre temps en mémoire les combinaisons trouvées et
- après la fin de l'entrée des données, les combinaisons de lettres trouvées, permises, sont mises en mémoire, indiquées ou délivrées de façon acoustique, pour être réutilisées,
- dans le cas où l'on a trouvé une seule combinaison de chiffres et de lettres autorisée on laisse se dérouler le fonctionnement/action correspondant de l'appareil,
- dans le cas où l'on a trouvé plusieurs combinaisons de lettres et de chiffres paraissant autorisées, celles-ci sont indiquées ou délivrées de façon acoustique sous la forme d'un menu de sélection et, sur la base d'un autre ordre d'entrée de données, on cherche la combinaison voulue et on laisse opérer le fonctionnement/action correspondant de l'appareil.

2. Procédé selon la revendication 1,
caractérisé en ce que
- le clavier contient un clavier numérique, de préférence un clavier à dix touches, et
- des chiffres uniques sont associés respectivement à quelques lettres.

3. Procédé selon la revendication 2,
caractérisé en ce qu'
on n'associe pas plus de trois lettres à chaque chiffre.

4. Procédé selon l'une des revendications 1 à 3,
caractérisé en ce qu'
on affiche l'indication relative à des combinaisons de chiffres et de lettres autorisées que l'on a trouvées au moyen d'un ou plusieurs signes particuliers , de préférence par des flèches, sur un écran.

5. Procédé selon l'une des revendications 1 à 4,
caractérisé en ce qu'
on prévoit une ou plusieurs touches non numériques pour établir une différence à l'intérieur des fréquences d'utilisation, de préférence pour passer d'une signification de lettres à une signification de chiffres, ou sous la forme d'une touche vide.

6. Procédé selon l'une des revendications 1 à 5,
caractérisé en ce que
les combinaisons alphanumériques autorisées et l'utilisation correspondante du clavier dans la mémoire de l'ordinateur sont enregistrées par une carte agile, par une mémoire extérieure, ou par un autre ordinateur.

7. Procédé selon l'une des revendications 1 à 6,
caractérisé en ce qu'
- on utilise comme appareil électrique un récepteur radio,
- dans la mémoire (71) du récepteur radio on dépose des désignations d'émetteurs sous la forme de combinaisons de lettres et de chiffres, et
- l'ordinateur, d'après l'entrée des données alphanumériques de l'émetteur, compare les identifications des émetteurs reçus au moyen d'un décodeur RDS, à celles des émetteurs choisis, et règle la fréquence correspondante dans un bloc d'accord.

8. Procédé selon l'une des revendications 1 à 6,
caractérisé en ce que
- dans la mémoire on dépose une table contenant des codes postaux numériques et/ou des longitudes et des latitudes géographiques et/ou des numéros matricules de véhicules à moteur, et
- on introduit les codes postaux numériques ou les lettres d'identification des véhicules à moteur pour déterminer la position ou le lieu de destination.

9. Procédé selon la revendication 8,
caractérisé en ce qu'
- on introduit, après l'introduction de la position, un autre lieu au moyen d'un code postal numérique ou de lettres d'immatriculation des véhicules à moteur, et
- l'ordinateur calcule, à partir des longitudes et des latitudes ou des lettres d'immatriculation des véhicules à moteur, la direction et la distance et, le cas échéant, affiche sur un écran un ou plusieurs itinéraires.
